Europäisches Patentamt

European Patent Office

Office européen des brevets

(11) Veröffentlichungsnummer: **0 268 935 B1**

# (12) EUROPÄISCHE PATENTSCHRIFT

(45) Veröffentlichungstag der Patentschrift: **18.12.91**

(21) Anmeldenummer: **87116665.8**

(22) Anmeldetag: **11.11.87**

(51) Int. Cl.⁵: **H01L 23/34**

(54) Senkrecht steckbares Single-in-line-Schaltungsmodul.

(30) Priorität: **28.11.86 DE 3640694**

(43) Veröffentlichungstag der Anmeldung:
**01.06.88 Patentblatt 88/22**

(45) Bekanntmachung des Hinweises auf die
Patenterteilung:
**18.12.91 Patentblatt 91/51**

(84) Benannte Vertragsstaaten:
**AT BE CH DE ES FR GB GR IT LI LU NL SE**

(56) Entgegenhaltungen:
**EP-A- 0 046 605**
**EP-A- 0 048 938**
**DE-A- 3 605 692**
**GB-A- 1 187 595**

(73) Patentinhaber: **SIEMENS AKTIENGESELL-
SCHAFT**
**Wittelsbacherplatz 2**
**W-8000 München 2(DE)**

(72) Erfinder: **Kaindl, Michael**
**Vogelleite 12**
**W-8068 Pfaffenhofen(DE)**
Erfinder: **Piepenburg, Werner, Dipl.-Ing. (FH)**
**Lochhamerstrasse 117**
**W-8000 München 71(DE)**
Erfinder: **Vollmerhaus, Ernst, Dr. Ing.**
**Sollnerstrasse 71**
**W-8000 München 71(DE)**

## Beschreibung

Die Erfindung geht Von dem speziellen Schaltungsmodul aus, das im Oberbegriff des Patentanspruches 1 definiert ist und für sich mehrfach vorbekannt ist, vgl. z.B. die Europäischen Schutzrechte
* EP-A2-48 938 und
* EP-B1-48 938
sowie die Deutsche Patentanmeldung
* DE-A-36 05 692

Bei diesen bekannten Schaltungsmodulen werden einzelne Stellen auf dem - z.B. aus Keramik bestehenden - Träger lokal stark erhitzt, nämlich dort, wo diese Stellen durch die Widerstandsbahnen bedeckt sind. Die bei den bekannten/älteren Schaltungsmodulen zusätzlich auf der einen Seite des Trägers angebrachte metallische, gut wärmeleitende Kühlfläche verteilt die lokal im Betrieb entstehende Verlustwärme rasch so, daß die lokalen Erhitzungen im Träger im allgemeinen so stark verringert werden können, daß der Träger nicht mehr aufgrund seiner thermisch bedingten inneren Spannungen platzt.

Die Erfindung hat die Aufgabe, die Widerstandsbahn auf dem Träger so anzubringen, daß
* einerseits der Träger und damit das Schaltungsmodul möglichst klein gemacht werden kann, vor allem um bei der Anwendung des Schaltungsmoduls Platz sparen zu können,
* andererseits im Betrieb besonders hohe Temperaturen - auch lokal unter den jeweiligen Widerstandsbahnen - auftreten dürfen, ohne - zur Verbesserung der Kühlung - die Fläche der Widerstandsbahnen und die Flächen des Trägers stark erhöhen zu müssen und ohne zusätzliche Versteifungsmaßnahmen oder Kühlmaßnahmen anbringen zu müssen - also z.B. ohne unbedingt metallische Kühlbleche zusätzlich anbringen zu müssen, sowie
* der Herstellungsaufwand trotzdem möglichst gering ist.

Die Erfindung soll jedoch gestatten, notfalls auch noch ein Kühlblech zusätzlich anbringen zu können.

Ein solches, räumlich besonders kleines, thermisch besonders hoch belastbares Schaltungsmodul wird erfindungsgemäß durch die im Patentanspruch 1 angegebenen Maßnahmen zur Verfügung gestellt.

Es zeigte sich nämlich, daß die an einem Ende der Widerstandsbahn auftretende Verlustwärme nicht über die Kühlluft, sondern im erheblichen Maße auch über die Leitungen zu den Metallstiften und weiter über die Platine/Lochplatte, in welche das Schaltungsmodul gesteckt ist, abgeleitet wird. Es ist nämlich oft nicht so, wie zunächst vermutet werden könnte, daß die im Schaltungsmodul im Betrieb auftretende Verlustwärme im wesentlichen alleine über die Kühlluft abtransportiert wird und daß deshalb, nämlich wegen des lokal verschiedenen Luftwiderstandes, die Kühlluft das eine Ende der Widerstandsbahn, an dem diese breiter ist, mit größerer Kühlluft-Strömungsgeschwindigkeit und deshelb besser kühlen würde als das andere Ende dieser Widerstandsbahn, an dem diese schmäler ist. Obwohl wirklich die Kühlluft das breitere eine Ende besser als das schmälere andere Ende kühlt, wird das schmälere andere Ende, wenn es über eine genügend kurze Leitung mit den Metallstiften verbunden ist, im Betrieb deutlich zusätzlich über diese Metallstifte hinweg und damit über die Platine durch Wärmeleitung gekühlt.

Die in den Unteransprüchen angegebenen zusätzlichen Maßnahmen bieten verschiedene Wege, welche für sich oder gemeinsam einen besonders einfachen Aufbau und damit eine besonders einfache Herstellung der betreffenden Widerstandsbahn gestatten. Es gestatten nämlich die Maßnahmen gemäß Patentanspruch 2, ganz besonders wenig Herstellungsaufwand zu benötigen, indem die Form der Widerstandsbahn so gewählt wird, daß die betreffenden Widerstandsbahnen erfindungsgemäß dimensioniert sind, sowie 3, mit wenig Herstellungsaufwand die Widerstandsbahn erfindungsgemäß zu dimensionieren.

Die Erfindung wird anhand der in den vier Figuren gezeigten Ausführungsbeispiele weiter erläutert. Hierbei zeigen die Figuren
1 und 2 einen Querschnitt und eine dazu senkrechte Seitenansicht eines Beispiels eines erfindungsgemäß aufgebauten Schaltungsmoduls,
3 ein Beispiel für die Dimensionierung der Widerstandsbahn gemäß Patentanspruch 2, sowie
4 ein Beispiel für die Dimensionierung der Widerstandsbahn gemäß Patentanspruch 3.

Die Erfindung wurde vor allem für Schaltungsmodule mit Widerstandsbahnen entwickelt, welche als Einspeisewiderstände an Teilnehmerleitungen eines digitalen Fernsprech-Vermittlungssystems (EWSD) dient und welche in besonderen Fällen auch noch zusätzliche elektrische Bauelemente, z.B. einen Kondensator und/oder Schmelzsicherungen, tragen können. Solche Schaltungsmodule sind dort in sehr hoher Zahl, z.B. 100 000 Stück, dicht gedrängt in Schränken unterzubringen, so daß ihre Kühlung besonders in Zeiten mit hoher Vermittlungstätigkeit bei hochsommerlichem Klima erhebliche Probleme macht. Die Erfindung ist jedoch auch für Schaltungsmodule geeignet, die nicht in einem solchen Vermittlungssystem angebracht werden, sondern z.B. in Stromversorgungsanlagen.

Die Widerstandsbahnen können auch bei der Erfindung in Dickschicht- oder Dünnfilmtechnik hergestellt sein. Die Erfindung ist also nicht eng auf eine spezielle Herstellungstechnik beschränkt.

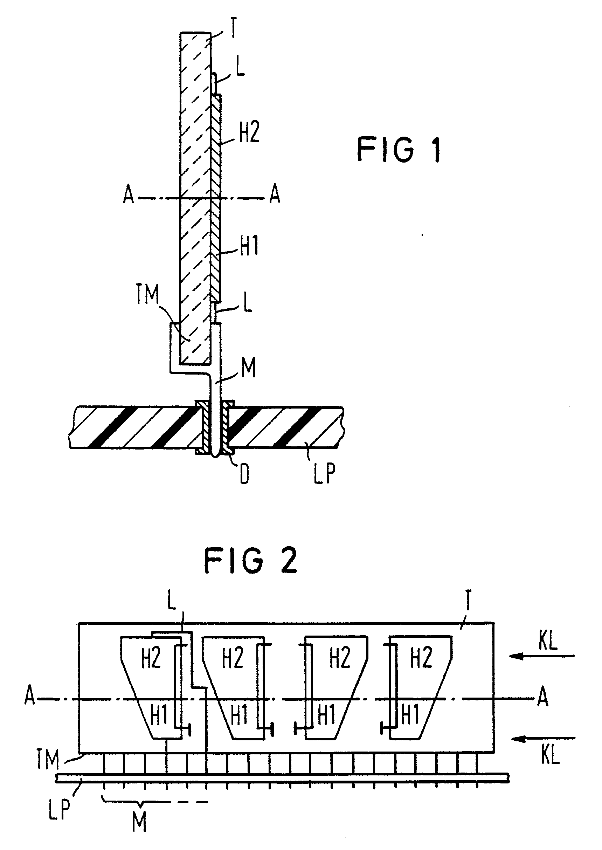

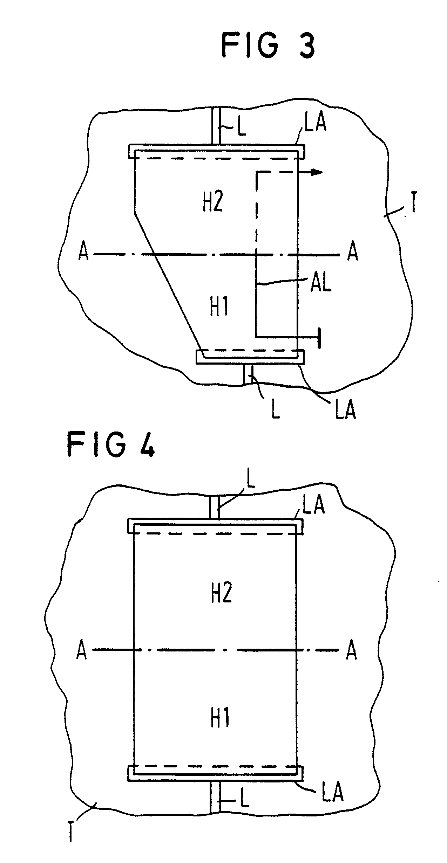

In den Figuren 1 bis 4 sind also Beispiele für einen Träger T gezeigt, der z.B. aus Keramik besteht und der, vgl. Fig. 1 und 2, eine Reihe von in der Trägerebene liegenden, längs einer Trägerkante TM angebrachten Metallstiften M als äußere elektrische Anschlüsse trägt. Außerdem trägt dieser Träger T noch Leitungen L, welche z.B. über leitende Kontaktflächen LA, vgl. Fig. 3 und 4, die Verbindungen zwischen den Widerstandsbahnen einerseits und den Metallstiften M andererseits herstellen, vgl. Fig. 1 und 2, und/oder welche z.B. die elektrischen Verbindungen zwischen verschiedenen, auf demselben Träger T angebrachten Widerstandsbahnen herstellen.

Dieser Träger T trägt also zusätzlich eine oder mehrere Widerstandsbahnen. Die Wärmeableitung der in den Widerstandsbahnen produzierten Verlustleistung erfolgt dabei nicht nur über die Kühlluft KL, sondern ebenfalls über die Leitungen L. Aufgrund der schaltungstechnischen Gegebenheiten ist die Wärmeableitung über die Leitungen L an dem einen Ende der Widerstandsbahnen, das über eine kurze Leitung L mit den Metallstiften M verbunden ist, größer als am anderen Ende, das über eine lange Leitung L oder andere dazwischenliegende Bauelemente mit den Metallstiften M verbunden ist.

Der Träger T, besonders wenn er aus einer modernen, extrem gut wärmeleitenden Keramik besteht, wird lokal jeweils dort stark erhitzt, wo er unmittelbar von der Widerstandsbahn bedeckt ist, vgl. besonders Fig. 1 und 2. Die vom Träger T lokal aufgenommene Verlustwärme breitet sich dann über den Träger T aus und wird, vgl. Fig. 2, teilweise direkt von der - bevorzugt mittels eines Gebläses zugeführten Kühlluft KL abtransportiert, jedoch im Bereich des einen Endes auch über die Metallstifte M und weiter über die Durchführungen D und über die Platinen/Lochplatten LP durch Wärmeleitung.

Da die Wärmeleitfähigkeit des Trägers T jedoch begrenzt und nicht unendlich gut ist, verursachen die Widerstandsbahnen in den Trägerbereichen unter den Widerstandsbahnen jeweils lokale, mehr oder weniger starke Aufheizungen (Hot spots) mit Temperaturen, die - wenn keine besonderen Vorsichtsmaßnahmen getroffen werden - teilweise über der zulässigen Schichttemperatur von z.B. 125˚C liegen. Um lokale Überhitzungen zu vermeiden, wurden bisher die Schaltungsmodule z.B. mit den im Stand der Technik genannten Aluminiumkühlblechen beklebt. Da z.B. Aluminium eine um den Faktor 10 bessere Wärmeleitfähigkeit gegenüber den Keramikträgern besitzt, wurde damit eine günstige Wärmeverteilung erreicht, d.h. ein geringer Temperaturunterschied längs des Trägers T, wodurch auch eine Senkung der lokalen Temperaturen in den Trägerbereichen unter den Widerstandsbahnen erreicht wird. Die Befestigung dieser Aluminiumbleche an den Trägern bereitet jedoch gelegentlich erhebliche Probleme vor allem für Anwendungen unter extremsten Betriebsbedingungen, vgl. das obengenannte Vermittlungssystem, was nur durch ganz besondere Vorsicht - wenn überhaupt - noch beherrscht werden kann, vgl. z.B. die oben genannte Deutsche Patentanmeldung

  * DE-A-36 05 692.

Es wurde jedoch nach einem neuen weiteren Weg gesucht, welcher für sich - möglichst sogar zusätzlich zu den vorbekannten/vorbeschriebenen Maßnahmen - gewählt werden kann um höchste thermische Belastungen der Schaltungsmodule trotz ihrer Kleinheit und trotz schwieriger Kühlungsbedingungen zulassen zu können, wobei die Herstellung der Schaltungsmodule auch in Serienfertigung ohne ungewöhnlich große Sorgfalt, also ohne besondere Schwierigkeiten möglich sein sollte.

Bei der Erfindung wird eine optimale Anordnung und Dimensionierung der Widerstandsbahnen auf dem Träger T, also z.B. auf dem Keramikträger T, gewählt, wodurch eine relativ mäßige lokale Aufheizung des Trägers T erreichbar ist, und zwar selbst wenn noch kein zusätzliches Aluminiumblech angebracht wird.

Weil mittels der Single-in-line-Bauweise, vgl. Fig. 1 und 2, eine nicht unwesentliche, zusätzliche Wärmeableitung in Richtung Platine/Leiterplatte LP über die Metallstifte M erreichbar ist, wird also erfindungsgemäß - zur Verbesserung der Gleichmäßigkeit der Temperaturverteilung auf dem Träger T - nahe den Metallstiften M eine höhere Verlustwärmeleistung pro Volumeneinheit durch Abnahme der Querschnittsfläche der Widerstandsbahn in Richtung des einen Endes zugelassen.

Zur vereinfachten Erklärung der Erfindung werde der Träger T nun gedanklich in zwei Bereiche unterteilt, vgl. die Trennlinie A-A in den Figuren. Durch die Linie A-A werden auch die Widerstandsbahnen gedanklich in zwei Sektoren geteilt, nämlich

  * in einen ersten Sektor H1, dessen Verlustwärmeleistung zwar teilweise direkt durch die Kühlluft KL, zusätzlich aber zu einem erheblichen Teil über die Metallstifte M und weiter über die Platine/Lochplatte PL durch Wärmeleitung abgeleitet wird, sowie

  * in einen zweiten Sektor H2, dessen Verlustwärmeleistung im wesentlichen nur durch die Kühlluft KL abtransportiert wird, vgl. Fig. 2.

Um eine derart dimensionierte Verlustwärmeleistung auf dem relativ kleinen Schaltungsmodul zulassen zu können, wird also z.B. der ohmsche Eigenwiderstand des ersten Sektors H1 anders dimensioniert als der ohmsche Eigenwiderstand des zweiten Sektors H2. Diese Eigenwiderstände sind nämlich proportional zu den von diesen Sektoren abgegebenen Verlustwärmeleitungen.

Im Sektor H1 kann man den Eigenwiderstand hochohmiger als im Sektor H2 z.B. dadurch machen, daß man die Schichtbreite (Fig. 2 und 3) und/oder die Schichtdicke (Fig. 4) der Widerstandsbahn, jeweils gemessen senkrecht zur Stromrichtung, kleiner macht als die entsprechende Schichtbreite bzw. entsprechende Schichtdicke dieser Widerstandsbahn im zweiten Sektor H2. Hierbei wird erfindungsgemäß der relativ hochohmige Sektor H1 möglichst dicht bei den elekrisch - und thermisch! - leitenden Metallstiften M angebracht.

Bei der Erfindung können nicht nur eine einzige, sondern gleichzeitig mehrere so dimensionierte Widerstandsbahnen auf einem einzigen Träger T angebracht werden, vgl. Fig. 2.

Wenn man gemäß dem in Fig. 4 gezeigten Beispiel die Schichtdicken beider Sektoren H1 und H2, gemessen senkrecht zur Trägeroberfläche, unterschiedlich machen will, dann kann man dies z.B. dadurch erreichen,

  * daß man bei Dickschicht-Siebdrucktechnik den dickeren Sektor H2 durch mehrmaliges Aufdrucken der Schichtwiderstandspaste herstellt, wobei die jeweils nächste obere Pastenschicht erst nach dem genügenden Trocknen/Härten der nächstunteren Pastenschicht aufgedruckt wird, sowie
  * daß man bei Dünnschicht-Aufdampf- oder -Aufsprühtechnik den dickeren Sektor H2 durch längeres oder mehrmaliges Aufdampfen/Aufsprühen einer Widerstandsschicht mittels einer entsprechenden, den ersten Sektor H1 schützenden Maske herstellt.

Zur präzisen Justierung des jeweils erwünschten Wertes des ohmschen Widerstandes kann man in für sich bekannter Weise mittels eines gebündelten Laserstrahles, wie in Fig. 3 angedeutet ist, einen Abschnitt der Widerstandsbahn teilweise oder ganz abtrennen. Während einer Messung des jeweils gegebenen Widerstandswertes der Widerstandsbahn so weit bewegt man den Laserstrahl z.B. entlang der Spur, die als Pfeil eingetragen ist, bis der Widerstandswert stimmt, vgl. auch Fig. 2. Wenn man hierbei, wie in Fig. 3 und 2 angedeutet ist, die Spur des Laserstrahles im ersten Sektor H1, z.B. an einer Randstelle desselben, beginnen läßt, wird durch diese Laserbearbeitung zusätzlich der Eigenwiderstand gerade dieses ersten Sektors H1 gegenüber dem Eigenwiderstand des zweiten Sektors H2 in erfindungsgemäßer Weise erhöht. - In ähnlicher Weise kann man auch den Widerstandswert von anders als in Fig. 3 geformten Widerstandsbahnen durch einen Laserstrahl justieren, also z.B. auch die in Fig. 4 gezeigte Widerstandsbahn - und zwar z.B. ebenfalls, indem man die Laserspur jeweils im ersten Sektor H1 an einer Randstelle beginnt, wodurch auch dort die erfindungsgemäße Dimensionierung dieses ersten Sektors H1 gefördert wird.

## Patentansprüche

1.  Senkrecht steckbares Single-in-Line-Schaltungsmodul mit einem Träger (T) zum Tragen von

    a) einer Reihe von in der Trägerebene liegenden, längs einer Trägerkante (TM) single-in-line angebrachten Metallstiften (M) als äußeren elektrischen Anschlüssen,

    b) einer oder mehreren ohm'schen Widerstandsbahnen in Dickschicht- und/oder Dünnschichttechnik, wobei die Wärmeableitung für die Verlustleistung der Widerstandsbahnen über Leitungen (L) an einem Ende der Widerstandsbahnen größer ist, als über Leitungen (L) an deren anderem Ende,

    **dadurch gekennzeichnet, daß**

    c) die Widerstandsbahnen so geformt sind, daß ihre Querschnittsfläche in Richtung des genannten einen Endes in der Weise abnimmt, daß bei Stromdurchfluß auf dem Träger (T) eine im wesentlichen gleichmäßige Temperaturverteilung erzielt wird.

2.  Schaltungsmodul nach Patentanspruch 1, **dadurch gekennzeichnet, daß** die Abnahme der Querschnittsfläche durch Abnahme der Schichtbreite der Widerstandsbahn erzielt wird.

3.  Schaltungsanordnung nach Patentanspruch 1, **dadurch gekennzeichnet, daß** die Abnahme der Querschnittsfläche durch die Abnahme der Schichtdicke der Widerstandsbahn erzielt wird.

## Claims

1.  Vertical plug-in single-in-line circuit module having a carrier (T) for carrying

    a) a series of metal pins (M), located in the plane of the carrier and mounted in a single-in-line fashion along an edge of the carrier (TM), as external electrical terminals,

    b) one or more ohmic resistor paths in thick film and/or thin film technology, the thermal dissipation for the power loss of the resistor paths via leads (L) at one end of the resistor paths being greater than via leads (L) at their other end, characterised in that

    c) the resistor paths are shaped such that their cross-sectional area decreases in the direction of the said one end in such a manner that, when current flows on the carrier (T), an essentially even temperature distribution is achieved.

2. Circuit module according to Patent Claim 1, characterised in that the reduction of the cross-sectional area is achieved by means of reduction of the film width of the resistor path.

3. Circuit arrangement according to Patent Claim 1, characterised in that the reduction of the cross-sectional area is achieved by means of the reduction of the film thickness of the resistor path.

**Revendications**

1. Module de circuit enfichable perpendiculairement du type à une rangée de connexions en ligne, comportant un support (T) servant à supporter
   a) une rangée de broches métalliques (M) situées dans le plan du support, disposées selon une seule rangée le long d'un bord (TM) du support et agencées sous la forme de bornes électriques extérieures,
   b) une ou plusieurs bandes formant résistances ohmiques utilisées dans la technique à couches épaisses ou à couches minces, l'évacuation de chaleur pour la puissance dissipée des bandes formant résistances par l'intermédiaire des conducteurs (L) situés à une extrémité des bandes formant résistances étant supérieure à l'évacuation de chaleur réalisée par l'intermédiaire des conducteurs (L) au niveau de l'autre extrémité,
   caractérisé par le fait que
   c) les bandes formant résistances sont conformées de telle sorte que leur surface en coupe transversale diminue en direction de ladite extrémité de manière que, lors du passage du courant, on obtient sur le support une répartition de température sensiblement uniforme.

2. Module de circuit suivant la revendication 1, caractérisé par le fait que la réduction de la surface en coupe transversale est obtenue au moyen d'une réduction de la largeur de couche de la bande formant résistance.

3. Montage suivant la revendication 1, caractérisé par le fait que la réduction de la surface en coupe transversale est obtenue au moyen de la réduction de l'épaisseur de couche de la bande formant résistance.

FIG 1

FIG 2

# FIG 3

# FIG 4